# EUROPEAN PATENT APPLICATION

(11) **EP 2 343 733 A1**
(43) Date of publication of application: **13.07.2011**
(21) Application number: 09814388.6
(22) Date of filing: 15.07.2009
(51) Int. Cl.: H01L 21/3065, G02B 1/11, G02B 5/02, H01L 21/306

(54) **SURFACE TREATMENT MASK, PROCESS FOR PRODUCING THE SURFACE TREATMENT MASK, METHOD FOR SURFACE TREATMENT, PARTICLE-CONTAINING FILM, AND PROCESS FOR PRODUCING THE PARTICLE-CONTAINING FILM**

(30) Priority: 19.09.2008 JP 2008241618; 19.09.2008 JP 2008241622
(71) Applicant: FUJIFILM Corporation, Tokyo 106-0031 (JP)
(72) Inventor: OGAWA, Shotaro, Fujinomiya-shi Shizuoka 418-8666 (JP); ICHIKAWA, Kimio, Odawara-shi Kanagawa 250-0001 (JP)
(74) Representative: Klunker . Schmitt-Nilson . Hirsch
(86) International application number: PCT/JP2009/062805
(87) International publication number: WO 2010/032543

(57) **Abstract**

This invention provides a surface processing mask having a film mask and a method for manufacturing the same. In the film mask, particles are present as a single layer without overlapping with each other or particles containing first particles and second particles having etching resistance lower than that of the first particles are contained. Moreover, the invention provides a surface processing method including disposing the film mask on the front surface of a process target, and etching the front surface to form irregularities and an optical device having a substrate processed by the surface processing method. Moreover, the invention provides a particle-containing film in which particles are arranged to form a single layer without overlapping with each other and a method for manufacturing the same.

## Description

### Technical Field

The present invention relates to a mask to be utilized in a surface processing method for forming irregularities on the front surface of a process target by etching, a method for manufacturing the mask, and a surface processing method. The present invention also relates to the field of optical device having a substrate processed by the surface processing method. The present invention also relates to a particle-containing film and a method for manufacturing the same.

### Background Art

Hitherto, in the field of optical devices such as solar cells, LEDs, and flat panel displays, formation of irregularities on the surface of a light transmitting substrate by etching has been performed in order to suppress a reflection phenomenon occurring when a difference in the refractive index at an interface though which a light transmits is large.

On the other hand, in the field of semiconductor devices, formation of irregularities on a substrate surface has been performed for obtaining an anchor effect in order to suppress release of a thin film resulting from, for example, insufficient adhesiveness of the thin film and the substrate.

In various fields, processing for forming irregularities on the front surface of a process target has been performed, and various proposals for the processing for forming irregularities have been made (e.g., Patent Documents 1 to 5).
[Patent Document 1] Japanese Patent Application Laid-Open (JP-A) No. 3-71677
[Patent Document 2] JP-A No. 2000-261008
[Patent Document 3] JP-A No. 2005-277295
[Patent Document 4] JP-A No. 2007-27564
[Patent Document 5] JP-A No. 2005-279807

### Disclosure of Invention

### Problems to be Solved by the Invention

In the surface processing methods including formation of irregularities that have been proposed, after disposing particles having a resistance to etching (etching resistance) on a front surface of a process target by a dry method or a wet method or adhering, to the surface of a process target, a film to which such particles have been blended, etching is carried out.

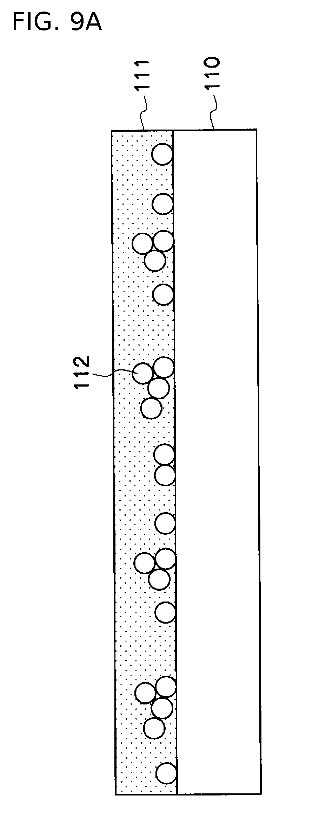

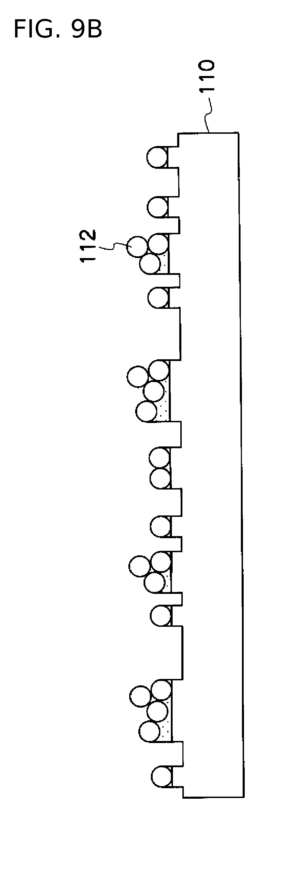

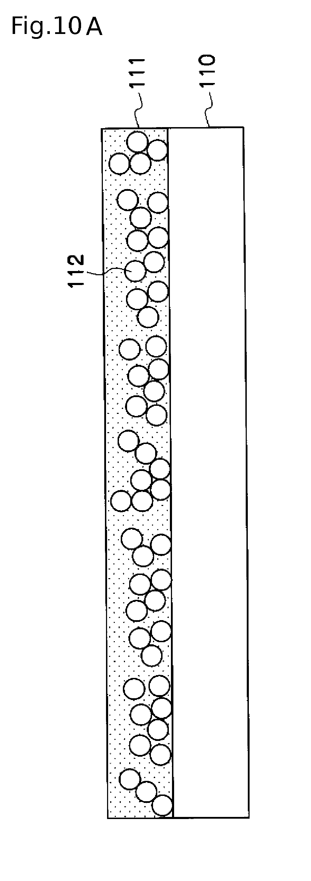

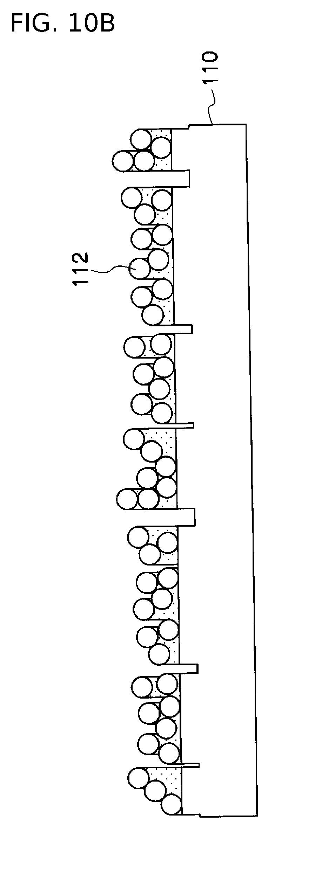

Even when any of these methods is employed, it is extremely difficult to have the particles be present as a single layer on the front surface of a process target. The particles are usually present with partial overlapping as viewed from the direction perpendicular to the front surface of the process target. When etching is carried out in this state, etching progresses only in spaces among the particles. Thus, only sporadic irregularities are formed, resulting in inconsistent quality of the processed articles. Specifically, for example, when the amount of the particles is small, nonstandard irregularities are likely to be formed on the front surface of the process target as shown in Fig. 9B. In contrast, when the amount of the particles is large, sporadic irregularities are likely to be formed due to overlapping particles as shown in Fig. 10B. Figs. 9A, 9B, 10A, and 10B are views for explaining a process of etching in a conventional surface processing method. Figs. 9A and 10A each show a state before the etching, and Figs. 9B and 10B each show a state after the etching. In Figs. 9A, 9B, 10A, and 10B, 110 represents a process target, 111 represents a film mask (particle layer), and 112 represents particles.

A process for removing such overlapping particles can also be carried out, but the process is complicated. In particular, when the process target has a large area, the process is unsuitable for mass production or cost reduction.

Films containing particles that are present as a single layer in which partial overlapping of the particles is suppressed have been demanded not only in the surface processing method but also in the fields of optical films (e.g., antireflection films, brightness increasing films, diffusion films, and reflective sheets), memory media, semiconductors and the like.

### Means for Solving the Problems

One aspect of the invention provides a surface processing mask that rarely causes inconsistent quality even when a process target has a large area, can form irregularities at a high speed, and has excellent aptitude to mass production and cost reduction, in addition to providing a method for manufacturing the same. Another aspect of the invention provides a surface processing method utilizing the surface processing mask. Another aspect of the invention provides an optical device having a substrate processed by the surface processing method. Still another aspect of the invention provides a particle-containing film in which particles are arranged to form a single layer without superimposing with each other in addition to a method for manufacturing the same.

Namely, the present invention provides the following <1> to <35>.

<1> A surface processing mask to form irregularities on a front surface of a process target, the surface processing mask comprising a film mask, and the film mask comprising:
a particle layer comprising particles and a first binder, a content of the first binder in the particle layer being less than a content of the particles in the particle layer in terms of volume, and the particles being exposed from the first binder; and
a binder layer comprising a second binder and including portions of the particles which are exposed from the first binder.

<2> A surface processing mask to form irregularities on a front surface of a process target, the surface processing mask comprising a film mask, the film mask comprising at least particles comprising first particles and second particles, and the second particles having an etching resistance that is less than an etching resistance of the first particles.

<3> The surface processing mask of <2>, wherein the film mask further comprises a binder.

<4> The surface processing mask of <2> or <3>, wherein ER1, which is an etching resistance of the first particles, ER2, which is an etching resistance of the second particles, and ER3, which is an etching resistance of the binder, satisfy the inequalities of ER2 < ER1 and ER3 < ER1.

<5> The surface processing mask according to any one of <2> to <4>, wherein the first particles are inorganic particles and the second particles are thermoplastic resin particles.

<6> The surface processing mask according to any one of <2> to <5>, wherein a content of the second particles is greater than a content of the first particles.

<7> The surface processing mask of <1>, wherein the binder layer is an adhesive layer that adheres the film mask to the process target.

<8> The surface processing mask according to any one of <1> to <7>, further comprising an adhesive layer that adheres the film mask to the process target.

<9> The surface processing mask according to any one of <1> to <8>, comprising a support substrate that supports a main surface of the film mask.

<10> The surface processing mask of <9>, comprising a release layer between the support substrate and the film mask.

<11> The surface processing mask of <9> or <10>, comprising a non-adhesive layer disposed on a surface that is opposite to the surface of the support substrate on which the film mask is disposed.

<12> The surface processing mask according to any one of <9> to <11>, comprising a protective film that covers another main surface that is opposite to the surface supported by the support substrate of the film mask.

<13> The surface processing mask according to any one of <1> to <12>, wherein the surface processing mask is roll-shaped or sheet-shaped.

<14> A surface processing method to forming irregularities on a front surface of a process target, the method comprising:
disposing the surface processing mask according to any one of <1> to <13> on the front surface of the process target; and
etching the front surface of the process target on which the surface processing mask is disposed to form irregularities on the front surface of the process target.

<15> The surface processing method of <14>, wherein:
a main surface of the film mask of the surface processing film is supported by a support substrate; and
disposing includes disposing the film mask on the front surface of the process target and then releasing the support substrate from the film mask.

<16> The surface processing method of <14> or <15>, wherein:
another main surface of the film mask that is opposite to the surface supported by the support substrate is covered with a protective film; and
the surface processing method includes releasing the protective film from the film mask before disposing.

<17> The surface processing method according to any one of <14> to <16>, wherein the disposing includes holding the film mask and the process target by using a roller under at least one of a vacuum decompression condition or a temperature condition higher than a glass transition temperature of the binder in the binder layer, so as to adhere the film mask and the process target.

<18> The surface processing method according to any one of <14> to <17>, wherein the etching is a dry etching.

<19> The surface processing method according to any one of <14> to <18>, wherein the front surface of the process target on which irregularities are to be formed is a light incident surface of an optical device.

<20> An optical device comprising a substrate, the substrate resulting from being subjected to the surface processing method according to any one of <14> to <19>.

<21> A method of manufacturing a surface processing mask to form irregularities on a front surface of a process target, the method comprising forming a film mask comprising a particle layer and a binder layer, and the film mask forming comprising: forming the particle layer comprising a first binder and particles exposed from the first binder by applying and drying a first coating liquid onto a base material, the first coating liquid comprising the particles and the first binder, a dry content of the first binder in the first coating liquid being less than a dry content of the particles in the first coating liquid in terms of volume; and
forming the binder layer by applying, onto the particle layer, a second coating liquid comprising a second binder so that the exposed particles are covered, and drying the applied second coating liquid.

<22> The method of manufacturing a surface processing mask of <21>, wherein the binder layer is an adhesive layer which adheres the film mask to the process target.

<23> A method of manufacturing a surface processing mask to form irregularities on a front surface of a process target, the method comprising forming a film mask comprising a particle layer, and the film mask forming comprising forming the particle layer by applying and drying a coating composition for forming a particle layer onto a base material, the coating composition comprising first particles and second particles, and the second particles having an etching resistance that is less than an etching resistance of the first particles.
<24> The method of manufacturing a surface processing mask of <23>, further comprising applying a coating composition to form an adhesive layer onto the particle layer and drying the coating composition to form an adhesive layer.

<25> The method of manufacturing a surface processing mask according to any one of <21> to <24>, wherein the base material is a support substrate that supports a main surface of the film mask.

<26> The method of manufacturing a surface processing mask according to any one of <21> to <25>, comprising forming a release layer between the base material and the film mask.

<27> The method of manufacturing a surface processing mask according to any one of <21> to <26>, comprising forming a non-adhesive layer on a surface that is opposite to a surface of the base material on which the film mask is formed.

<28> The method of manufacturing a surface processing mask according to any one of <21> to <27>, comprising forming a protective film on the film mask.

<29> The method of manufacturing a surface processing mask according to any one of <21> to <28>, wherein a method of applying the first coating liquid and the second coating liquid in the formation of the film mask is selected from a bar coating method, a roll coating method, a curtain coating method, an air knife coating method, and a gravure coating method.

<30> A method of manufacturing a particle-containing film, the method comprising:
forming the particle layer comprising a first binder and particles exposed from the first binder by applying and drying a first coating liquid onto a base material, the first coating liquid comprising the particles and the first binder, a dry content of the first binder in the first coating liquid being less than a dry content of the particles in the first coating liquid in terms of volume; and
forming the binder layer by applying, onto the particle layer, a second coating liquid comprising a second binder so that the exposed particles are covered, and drying the applied second coating liquid.

<31> A method of manufacturing a particle-containing film, the method comprising forming a particle layer by applying and drying a coating composition for forming a particle layer onto a base material, the coating composition comprising first particles and second particles, and the second particles having an etching resistance that is less than an etching resistance of the first particles.

<32> The method of manufacturing a particle-containing film of <30> or <31>, wherein a method of applying the first coating liquid and the second coating liquid is selected from a bar coating method, a roll coating method, a curtain coating method, an air knife coating method, and a gravure coating method.

<33> A particle-containing film comprising:
a particle layer comprising particles and a first binder, a content of the first binder in the particle layer being less than a content of the particles in the particle layer in terms of volume; and
a binder layer comprising a second binder, the particles being exposed from the first binder.

<34> A particle-containing film comprising first particles and second particles, the second particles having an etching resistance that is less than an etching resistance of the first particles.

<35> The particle-containing film of <33> or <34>, wherein the film is roll-shaped or sheet-shaped.

### Effect of the Invention

The invention may provide a surface processing mask that rarely causes inconsistent quality even when a process target has a large area, can form irregularities at a high speed, and has excellent aptitude to mass production and cost reduction, in addition to providing a method for manufacturing the same. The invention may further provide a surface processing method utilizing the surface processing mask. The invention may further provide an optical device having a substrate processed by the surface processing method. The invention may further provide a particle-containing film in which particles are arranged to form a single layer without superimposing with each other in addition to a method for manufacturing the same.

### BRIEF DESCRIPTION OF DRAWINGS

Fig. 1A is a view of a process in a surface processing method of one exemplary embodiment according to a first aspect of the invention.
Fig. 1B is a view of a process (continued from the process of Fig. 1A) in the surface processing method according to the exemplary embodiment.
Fig. 1C is a view of a process (continued from the process of Fig. 1B) in the surface processing method according to the exemplary embodiment.
Fig. 1D is a view of a process (continued from the process of Fig. 1C) in the surface processing method according to the exemplary embodiment.
Fig. 1E is a view of a process (continued from the process of Fig. 1D) in the surface processing method according to the exemplary embodiment.
Fig. 1F is a view of a process (continued from the process of Fig. 1E) in the surface processing method according to the exemplary embodiment.
Fig. 2A is a schematic view (plan view) of a mask for surface processing of one exemplary embodiment according to the first aspect of the invention.
Fig. 2B is a schematic view (sectional view) of the mask for surface processing of the exemplary embodiment.
Fig. 3A is a view of a process in a surface processing method of one exemplary embodiment according to a second aspect of the invention.
Fig. 3B is a view of a process (continued from the process of Fig. 3A) in the surface processing method according to the exemplary embodiment.
Fig. 3C is a view of a process (continued from the process of Fig. 3B) in the surface processing method according to the exemplary embodiment.
Fig. 3D is a view of a process (continued from the process of Fig. 3C) in the surface processing method according to the exemplary embodiment.
Fig. 3E is a view of a process (continued from the process of Fig. 3D) in the surface processing method according to the exemplary embodiment.
Fig. 3F is a view of a process (continued from the process of Fig. 3E) in the surface processing method according to the exemplary embodiment.
Fig. 4A is a view of a process (before etching) for explaining etching in a surface processing method according to one exemplary embodiment of the second aspect of the invention.
Fig. 4B is a view of a process (after etching) for explaining the etching in the surface processing method according to the exemplary embodiment.
Fig. 5 is a schematic cross sectional view showing a surface processing mask according to another exemplary embodiment of the second aspect of the invention.
Fig. 6A is a view of a process in a method for manufacturing a surface processing mask according to one exemplary embodiment of the first aspect of the invention.
Fig. 6B is a view of a process (continued from the process of Fig. 6A) in the method for manufacturing a surface processing mask according to the exemplary embodiment.
Fig. 6C is a view of a process (continued from the process of Fig. 6B) in the method for manufacturing a surface processing mask according to the exemplary embodiment.
Fig. 6D is a view of a process (continued from the process of Fig. 6C) in the method for manufacturing a surface processing mask according to the exemplary embodiment.
Fig. 6E is a view of a process (continued from the process of Fig. 6D) in the method for manufacturing a surface processing mask according to the exemplary embodiment.
Fig. 6F is a view of a process (continued from the process of Fig. 6E) in the method for manufacturing a surface processing mask according to the exemplary embodiment.
Fig. 7 is a schematic diagram showing a device for manufacturing a surface processing mask according to one exemplary embodiment of the invention.
Fig. 8A is a perspective view for explaining the shape (roll shape) of a surface processing mask of one exemplary embodiment of the invention when the mask is stored.
Fig. 8B is a perspective view for explaining the shape (disposed in a sheet shape) of a surface processing mask of one exemplary embodiment of the invention when the mask is stored.
Fig. 9A is a view of a process (before etching) for explaining etching in a surface processing method according to one conventional surface processing method.
Fig. 9B is a view of a process (after etching) for explaining the etching in the surface processing method according to the conventional surface processing method.
Fig. 10A is a view of a process (before etching) for explaining etching in a surface processing method according to another conventional surface processing method.
Fig. 10B is a view of a process (after etching) for explaining the etching in the surface processing method according to the conventional surface processing method.

### BEST MODES FOR CARRYING OUT THE INVENTION

Hereinafter, embodiments of the present invention will be described with reference to the drawings. There may be a case that an explanation of a matter which is the same as that previously described is omitted.

### Surface processing method according to First aspect

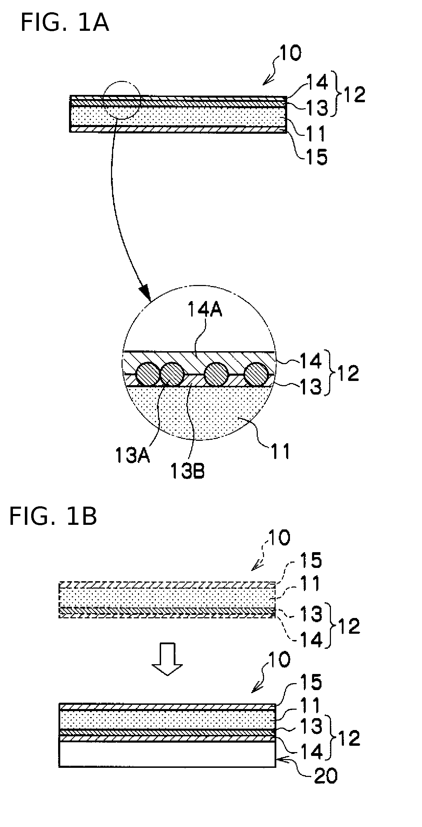

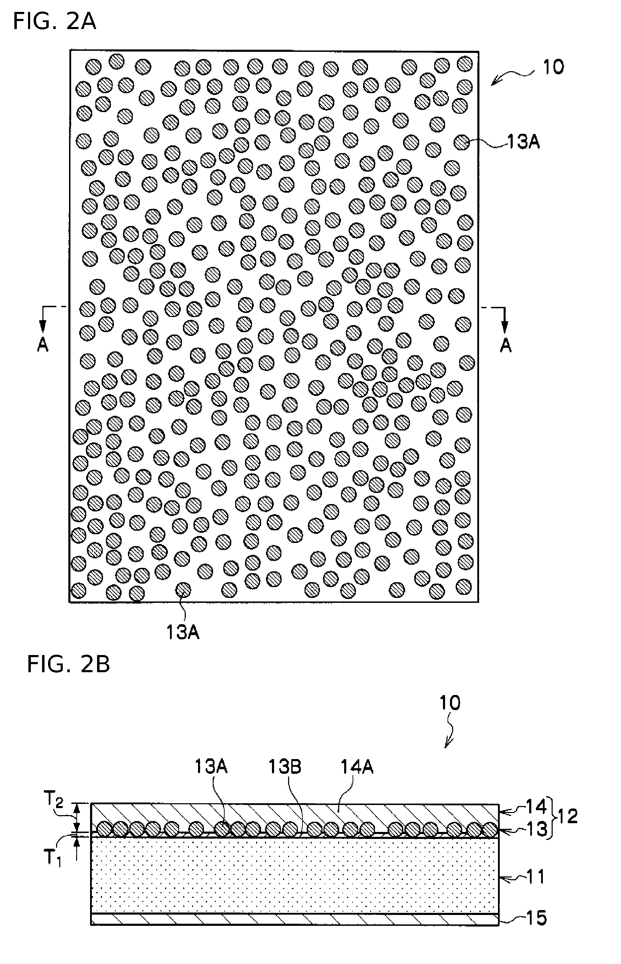

Figs. 1A to 1F are views of processes in a surface processing method according to one exemplary embodiment of a first aspect of the invention. Figs. 2A to 2B are schematic views showing a surface processing film according to another exemplary embodiment of the first aspect of the invention, in which Fig. 2A shows a plan view and Fig. 2B shows a cross sectional view. Fig. 1B shows a cross sectional view along the A-A line in Fig. 2A.

In the surface processing method according to one exemplary embodiment of the first aspect of the invention, a surface processing mask 10 is firstly prepared as shown in Fig. 1A. The surface processing mask 10 has a structure in which a film mask 12 is disposed on a support substrate 11, to the rear surface of which a non-adhesive layer 15 is disposed as shown in Fig. 2B.
The film mask 12 contains a particle layer 13 and a binder layer 14, in which the particle layer 13 contains particles 13A having etching resistance and a binder 13B having a volume smaller than that of the particles 13A and in which the particles 13A are exposed, and the binder layer 14 contains a binder 14A and covers the exposed particles 13A.
Here, the state where "the particles (13A) are exposed" refers to a state where at least one portion of each particle (13A) is present on or above the outermost surface of the particle layer (i.e., a region which is the surface of a matrix formed of the binder (13B) of the particle layer and to which the support substrate (11) is not disposed).

Next, as shown in Fig. 1B, the film mask 12 and a target substrate 20 (a target that is to be processed) are made to face each other in such a manner that the binder layer 14 of the film mask 12 contacts the target substrate 20, and then the surface processing mask 10 is disposed on the target substrate 20. Thus, the film mask 12 (binder layer 14 of the film mask 12) in the surface processing mask 10 is adhered to the front surface of the target substrate 20.

Here, the kind of the target substrate 20 is not particularly limited. Examples of the target substrate 20 include: a substrate containing, as a component thereof, a semiconductor (e.g., a silicon substrate), an electrically conductive substance, an insulator or the like; a glass substrate for use in flat panel displays; and materials obtained by forming a functional layer (e.g., a wiring layer and an insulating layer) on any one of such substrates.

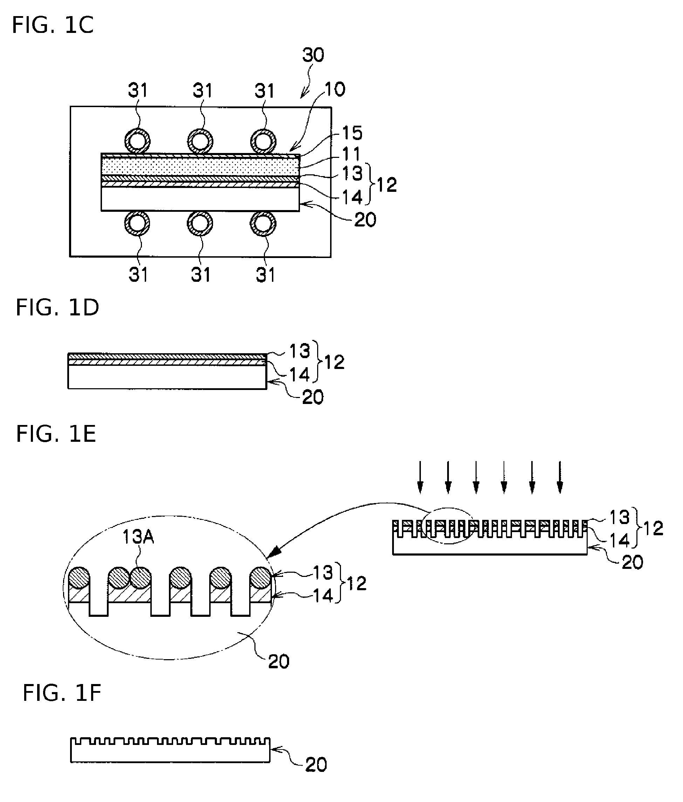

Next, as shown in Fig. 1C, the target substrate 20 on which the surface processing mask 10 is disposed is inserted into a laminate device 30. Then, a pressure is applied between the surface processing mask 10 and the target substrate 20, i.e., between the film mask 12 and the target substrate by, for example, holding the target substrate 20, on which the surface processing mask 10 is disposed, by tubular holding rollers 31 disposed in the laminate device 30. (The number of the holding rollers is not particularly limited. This embodiment describes the case where three roller pairs are provided.) Thus, the surface processing mask 10 and the target substrate 20, i.e., the film mask 12 and the target substrate 20, are welded by pressure. The film mask 12 is thus adhered to the target substrate 20 to be fixed.

When the binder layer 14 of the film mask 12 is a thermal adhesive layer, the pressure welding using the holding rollers 31 may be accompanied by heating in a certain preferable embodiment.

In contrast, when the binder layer 14 of the film mask 12 is not an adhesive layer (the film mask 12 and the target substrate 20 are adhered to each other in such a manner that the particle layer 13 of the film mask 12 directly contacts the target substrate 20), the pressure welding using the holding rollers 31 can be performed, in a certain preferable embodiment, under at least one of a condition in which vacuum decompression is performed (e.g., under a vacuum decompression condition of 100 hPa or lower) or a condition in which a temperature is higher than the glass transition temperature of the binder 14A of the binder layer 14 in the film mask 12. Specifically, pressure welding can be performed under, for example, a vacuum decompression condition in view of increasing the adhesiveness between the film mask 12 and the target substrate 20 (namely, in view of suppressing intervention with air bubbles). On the other hand, when the glass transition temperature of the binder 14A of the binder layer 14 which forms the film mask 12 is higher than the temperature of a manufacturing environment (typically room temperature, for example, 25°C), pressure welding may be performed at a temperature higher than the glass transition temperature.

Examples of preferable pressure welding conditions using the holding rollers 31 include conditions in which pressure welding is performed at a rate of from 0.1 m/minute to 3 m/minute while maintaining the pressure at from 20 psi to 50 psi to the rollers under a temperature of from 50°C to 150°C and an atmospheric pressure of 10 hPa. In view of improving productivity, the pressure welding process is preferably continuously performed and, in such a case, a known continuous treatment type vacuum laminator can be used.

When the pressure welding is accompanied by heating, a heating source (not shown) may be disposed in the holding rollers or may be disposed in another position other than the holding rollers.

Next, as shown in Fig. 1D, the support substrate 11 is released from the target substrate 20 to which the surface processing mask 10 (film mask 12) has been welded by pressure. Thus, the film mask 12 is made to remain on the front surface of the target substrate 20 (Fig. 2A).

The support substrate 11 may be released before the pressure welding performed using the holding rollers 31 (laminate device 30). In this case, the surface of the rollers (rollers in the upper side in Fig. 1C) arranged at the side contacting the surface processing mask 10 among the holding rollers 31 are preferably formed of a material having favorable mold-release properties (e.g., polytetrafluoroethylene).

Examples of a method for releasing the support substrate by a releasing device include a method including adhering a pressure-sensitive adhesive tape to the support substrate tip portion to release the support substrate, a method including spraying compressed air to the support substrate tip portion to release the support substrate, and a method including irradiating the support substrate with laser light to release the support substrate.

Next, as shown in Fig. 1E, the target substrate 20 to which the film mask 12 is adhered is etched from the side to which the film mask 12 is adhered. Thus, in the front surface of the target substrate 20, the regions covered with the particles 13A, which have etching resistance and form the film mask 12, are not etched and, in contrast, the regions excluding the regions covered with the particles 13A (namely, regions in which the particles 13A are projected to the target substrate 20 as viewed from the etching direction) are etched to form concave portions.

Specifically, when etching is carried out, the regions which are formed of the binder 13B which forms the particle layer 13 and the binder layer 14 and are other than the regions covered with the particles 13A are etched and, surface regions of the target substrate 20 corresponding to the etched regions are also etched.

Thus, on the front surface of the target substrate 20, regions which are etched become concave portions and regions which are not etched become convex portions, so that irregularities on the front surface of the target substrate 20 are formed. In the regions to be etched (regions excluding the regions covered with the particles 13A), the front surface of the target substrate 20 is etched together with the film mask 12 (particle layer 13 and binder layer 14).

Next, as shown in Fig. 1F, the film mask 12 is released (removed) from the target substrate 20 that has been etched.

Through the processes above, the front surface of the target substrate 20 can be subjected to the irregularity formation processing.

### Surface processing method according to second aspect

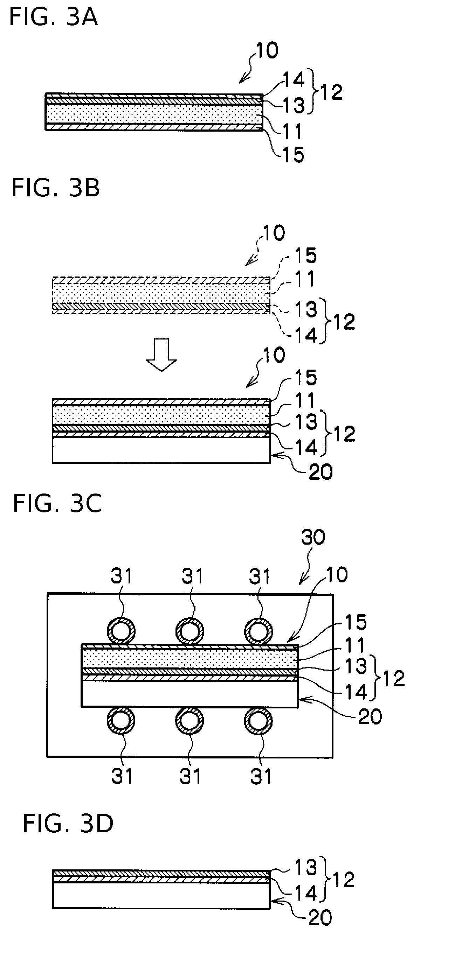

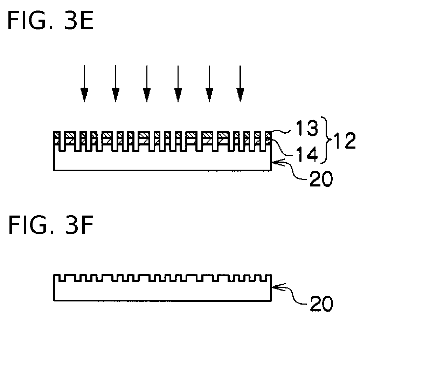

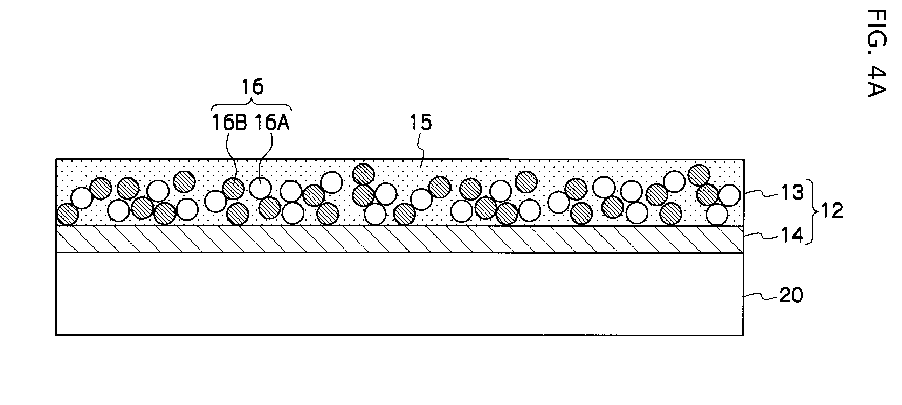

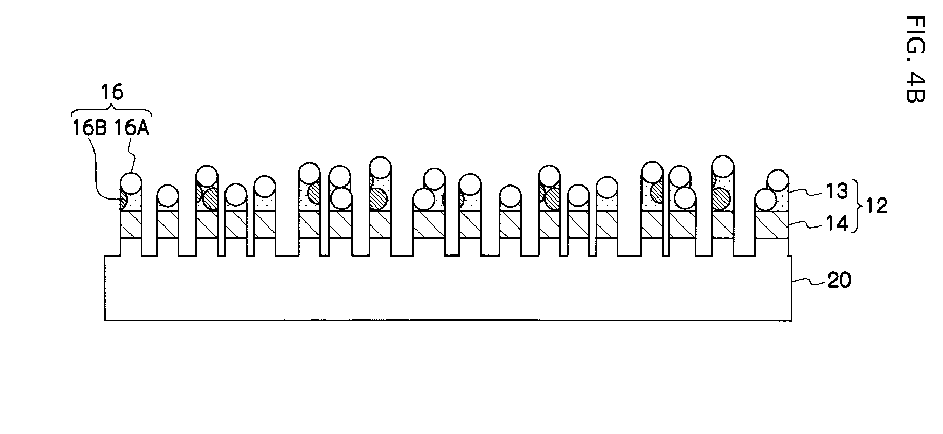

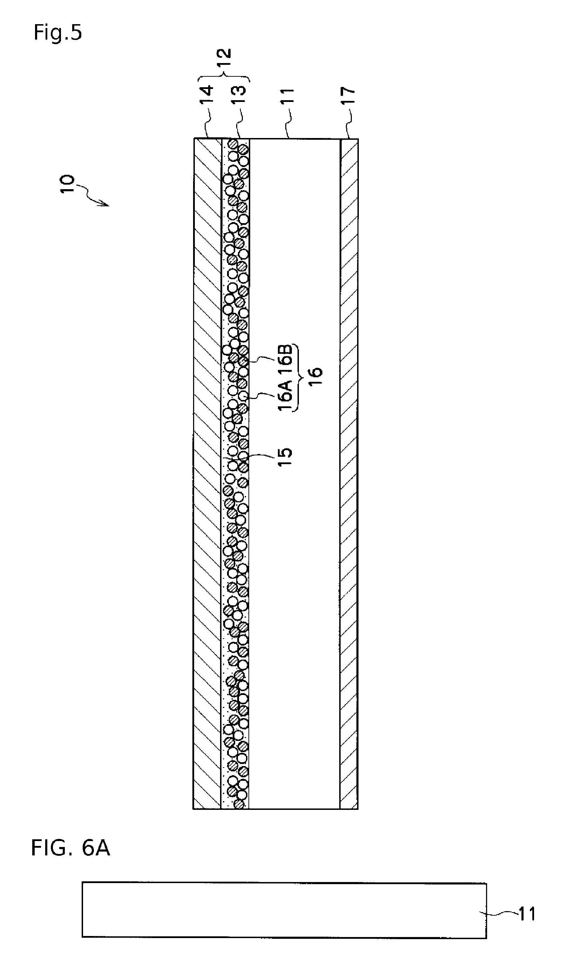

Figs. 3A to 3F are views of processes in a surface processing method according to one exemplary embodiment of a second aspect of the invention. Figs. 4A to 4B are views for explaining etching in the surface processing method according to one exemplary embodiment of the second aspect of the invention. Fig. 4A shows a state before the etching and Fig. 4B shows a state after the etching. Fig. 5 is a schematic cross sectional view showing a surface processing mask according to one exemplary embodiment of the second aspect of the invention.

In the surface processing method according to one exemplary embodiment of the second aspect of the invention, a surface processing mask 10 is firstly prepared as shown in Fig. 3A. The surface processing mask 10 has a structure in which a film mask 12 is disposed on a support substrate 11, to the rear surface of which a non-adhesive layer 17 is disposed as shown in Fig. 5.
The film mask 12 has a particle layer 13 and an adhesive layer 14, in which the particle layer 13 contains particles 16 which are dispersed and blended in a binder 15, and an adhesive layer 14 resides for adhering the film mask 12 to the target substrate 20. The particles 16 contain first particles 16A having etching resistance and second particles 16B having etching resistance lower than that of the first particles 16A. Subsequently, in a manner similar to the surface processing method according to the above-explained exemplary embodiment of the first aspect, the surface processing mask 10 is disposed on the target substrate 20, the obtained laminate is placed on a laminate device and subjected to pressure welding treatment to adhere and fix the surface processing mask 10 and the target substrate 20, and then the support substrate 11 is released from the target substrate 20 in the obtained pressure-welded material to thereby make the film mask 12 remain on the front surface of the target substrate 20. (The conditions of the target substrate, the conditions of the pressure welding treatment, and the conditions of release of the support substrate herein employed are similar to the conditions of the surface processing method of the above-explained exemplary embodiment according to the first aspect.) Subsequently, the target substrate 20 to which the film mask 12 is adhered (Fig. 4A) is etched from the side to which the film mask 12 is adhered. Thus, in the front surface of the target substrate 20, the regions covered with the first particles 16A, which have etching resistance and form the film mask 12, are not etched and, in contrast, the regions excluding the regions covered with the particles 16A (namely, regions in which the first particles 16A are projected to the target substrate 20 as viewed from the etching direction), are etched to form concave portions (Fig. 4B).

Specifically, when etching is carried out, the regions which are formed of the binder 15 which forms the particle layer 13 and the adhesive layer 14 and are other than the regions covered with the first particles 16A are etched and, surface regions of the target substrate 20 which are formed of the second particles 16B, which have etching resistance lower than that of the first particles 16A, are also etched.

Thus, on the front surface of the target substrate 20, regions which are etched become concave portions and regions which are not etched become convex portions, so that irregularities on the front surface of the target substrate 20 are formed. In the regions to be etched (regions excluding the regions covered with the first particles 16A), the front surface of the target substrate 20 is etched together with the film mask 12 (particle layer 13 and adhesive layer 14).

Next, the film mask 12 is released (removed) from the target substrate 20 that has been etched.

Through the processes above, the front surface of the target substrate 20 can be subjected to the irregularity formation processing.

The etching performed in the surface processing method may be either wet etching or dry etching, and dry etching is preferably performed. Examples of the dry etching method include known dry etching methods such as a reactive gas etching including exposing the target substrate 20 to reactive gas for etching and a reactive ion etching (RIE) including ionizing or radicalizing reactive gas by plasma for etching. Examples of devices for performing the dry etching method include known devices.

The conditions for carrying out the dry etching are determined as appropriate according to the thickness and the type of the film mask 12 (the type of the binder, the type of the particles, and/or the like). Preferably, the following conditions are adopted.
1) Dry etching can be performed using CF₄, C₂F₆, Cl₂, ClF₃, or the like as the reactive gas.
2) Preferable examples of highly anisotropic etching include RIE (Reactive Ion Etching) and RIBE (Reactive Ion Beam Etching) using gas, such as a combination of SiCl₄ and He or a combination of CH₄ and He.
3) Etching gas may permeates into the target substrate and causes chemical/physical changes in some cases depending on the type of the gas. Considering this, a period of time during which the target substrate is exposed to the etching gas can be optimized.
4) Examples of a method for removing residues in the case that the film mask partially remains after a desired irregular shape is obtained by etching includes: an ashing method which includes introducing gas, such as ozone or oxygen, and emitting light, such as ultraviolet rays, to remove the residues; and an ashing method which includes converting oxygen gas to plasma by high frequencies or the like and utilizing the plasma to remove the residues.

In the etching, the etching of the film mask of the surface processing mask and the etching of the target substrate 20 may be carried out by the same etching technique or may be individually carried out by different etching techniques.

In the surface processing method according to the exemplary embodiment of the first aspect described above, the target substrate is etched in a state in which the film mask is adhered, as a surface processing mask, to the target substrate, in which the film mask has the particles that are arranged to form a single layer without overlapping with each other. Since the particles are arranged to form a single layer without overlapping with each other on the target substrate, the regions to be etched in the target substrate can be sufficiently secured, and irregularities can be formed on the front surface of the target substrate together with suppressing the formation of irregularities at an atypical pitch or sporadic irregularities.

In the surface processing method according to the exemplary embodiment of the second aspect described above, the target substrate is etched in a state in which the film mask is adhered, as a surface processing mask, to the target substrate, in which the film mask has the particles including the first particles and the second particles which are dispersed and blended in the binder, in which the first particles have etching resistance, and the second particles have etching resistance lower than that of the first particles. When the etching is performed, the first particles are not etched, but the second particles, the etching resistance of which is lower than that of the first particles, are etched. Since the first particles thus serve as an etching mask, gaps between the first particles are secured. More specifically, even when the particles containing the first particles are arranged on the target substrate while overlapping with each other or being irregularly arranged, the region to be etched in the target substrate may be secured and irregularity formation processing may be given to the front surface of the target substrate together with suppressing the formation of irregularities at an atypical pitch or sporadic irregularities. Therefore, not depending on the arrangement of the particles (particularly, the first particles), irregularity formation processing may be given to the front surface of the target substrate 20.

In the surface processing method, the particles which work for selecting regions to be etched and regions not to be etched are disposed on the front surface of the target substrate by blending the particles in the binder in advance and adhering the film mask, which contains the binder which is formed in a layer structure, to the target substrate. Therefore, even when the front surface of the target substrate has a large area, the particles may be disposed on the front surface of the target substrate by simple and quick operation of adhering the film mask thereto. Moreover, since the film mask can be manufactured by blending the particles in the binder, products having a certain constant quality (i.e., products in which the particles do not overlap with each other and the interval of the particles arranged to form a single layer is in a certain range) can be manufactured in a simple manner.

Therefore, the surface processing method may hardly suffer from causing inconsistent quality of products even when process target has a large area, may allow formation of irregularities at a high speed, and may have excellent mass production properties and cost reduction suitability.

On the processed surface of the target substrate 20 (process target, for example, a light incident surface of a solar cell) by the surface processing method, the ratio of the number of the concave portions of the front surface of the process target having an equivalent diameter in the range of from 200 nm to 1000 nm to the total number of the concave portions may be preferably at least 60%, and still more preferably at least 80%.
The equivalent diameter is defined as follows. The surface shapes of concave portions of the processed surface of the target are measured by a contact type surface profilometer, such as a surface roughness meter, or a noncontact type surface profilometer, such as AFM (Atomic Force Microscope). The area of a portion surrounded by regions (closed curve) on the inner wall surface of the concave portions present at a 10% depth of a distance from a reference surface, which is a non-processed surface portion, i.e., a flat portion on which irregularities are not formed, to the bottom (deepest portion) of the concave portions in the direction toward the bottom (depth direction) of the concave portions, is then determined. The diameter of a circle (supposed circle) having the same area as the area determined above is defined as an equivalent diameter. The concave portions having an equivalent diameter of 10 nm or lower are herein considered as flat portions (portions on which irregularities are not formed) (i.e., the concave portions are not counted as the number of concaves).
For example, the concave portions actually measured when calculating the ratio of the number of the concave portions having a given equivalent diameter to the total number of the concave portions may be preferably at least 10, more preferably 50 or more, still more preferably 100 or more, and further preferably 500 or more, in the case that the calculation is performed for a light incident surface of a solar cell.
Specific examples of the measurement and calculation method of the area include the following. That is, "z0", that is the depth at the deepest portion in the contour map obtained from the shape measurement results measured in a non-contact mode by AFM, is firstly determined. Then "zij", that is the depth at each measurement position (i, j), is expressed by "zij = zij - 0.1 *z0", provided that 10% value of the z0 is expressed by "0.1 * z0", A contour map is formed again based on the zji, displayed and printed out, and then the area explained above can be determined by known methods from the printed-out contour line. The area can also be determined by directly processing digital data obtained from an AFM measurement device. Any established techniques can be used.

Details of the surface processing mask 10 to be applied to the surface processing method will be described hereinafter.

### Surface processing mask

The surface processing mask is obtained by disposing a film mask on a support substrate.
The surface processing mask can further have a non-adhesive layer disposed on the rear surface (surface opposite to the side on which the film mask is disposed) of the support substrate.
The surface processing mask can typically contain a film mask, a support substrate which supports the film mask from one surface, and a non-adhesive layer which suppresses adhesion of inner regions of the surface processing mask or adhesion of a plurality of surface processing masks when plural surface processing masks are plied or when the surface processing mask is formed into a roll shape. The surface processing mask may further have a protective film which covers a surface of the surface processing mask which is opposite to the surface to which the film mask is provided, a release layer which increases the releasability between the film mask and the support substrate, and/or the like. The surface processing mask manufacturing method described below may further include a process for forming the protective film or the release layer.

The surface processing mask may have an arbitrary structure insofar as it has the film mask. Specifically, for example, in the case that the film mask itself has a self-supporting property, the surface processing mask may have a structure substantially containing only the film mask and the protective film. In the case that adhesion of inner regions of the surface processing mask or adhesion of the surface processing masks may not occur when the surface processing mask is disposed or formed into a roll shape, it is not necessary to provide a non-adhesive layer in the surface processing mask.

### Film mask

### Film mask according to first aspect

The film mask according to the first aspect contains a particle layer and a binder layer, in which the particle layer contains particles having etching resistance and a binder having a volume smaller than that of the particles, the particles are exposed from the particle layer, and the binder layer contains a binder and covers the exposed particles.
The film mask may be obtained by: applying a first coating liquid containing particles having etching resistance and a binder having a volume after drying smaller than that of the particles onto a base material and drying the same to form the particle layer in which the particles are exposed; and applying a second coating liquid containing a binder onto the particle layer in such a manner as to cover the exposed particles and drying the same to form the binder layer.

A particle layer of the film mask may be usually formed through application of a coating liquid containing particles and a binder onto a base material and drying the same. During the application and drying, the binder concentration becomes high and it becomes difficult to move the particles in the coating film containing the particles and the binder, and thus the particles are hard to precipitate. Therefore, the particle layer (consequently, film mask having the particle layer) is formed in a state in which the particles are not arranged to form a single layer but overlapping with each other.

In one exemplary embodiment of the first aspect of the invention, a first coating liquid containing particles having etching resistance and a binder having a volume after drying smaller than that of the particles is first applied onto a base material to form a particle layer in which the particles are exposed. Here, the amount of the binder is small so that the particles are exposed from a surface of the particle layer to be formed. Therefore, during the application and drying, the binder concentration may not increase but a state in which the particles easily move may be achieved in the coating film containing the particles and the binder. Therefore, the particles may precipitate and be arranged to form a single layer without overlapping with each other. Subsequently, a second coating liquid containing a binder is applied onto the surface of the particle layer in which the particles are exposed so that the exposed particles are covered therewith, and the applied second coating liquid is dried to form a binder layer.

The thus-obtained surface processing mask (film mask) according to the first aspect contains particles present in an arrangement of forming a single layer without overlapping with each other. Therefore, as described above, it may provide a surface processing method which may hardly cause inconsistent quality even when the process target has a large area, may form irregularities at a high speed, and may have excellent mass production properties and cost reduction suitability.

The film mask according to the first aspect contains a particle layer and a binder layer, in which the particle layer contains particles having etching resistance and a binder having a volume smaller than that of the particles, the particles are exposed from the particle layer, and the binder layer contains a binder and covers the exposed particles.

The average thickness T1 of the particle layer of the film mask according to the first aspect is preferably from 0.05 µm to 3 µm, and more preferably from 0.1 µm to 1 µm. The average thickness T2 of the adhesive layer of the film mask according to the first aspect is preferably from 0.3 µm to 4 µm, and more preferably from 0.4 µm to 1.5 µm. The average thickness of each layer means the thickness achieved by the binder without the particles. Specifically, in Fig. 2B, T1 represents the thickness of the particle layer and T2 represents the thickness of the binder layer.

In the film mask according to the first aspect, the particles are contained in the particle layer with being arranged to form a single layer. The particles need not to be closely disposed, and may be disposed with an interval between the particles. More specifically, the particle layer may be formed by adjusting the particle amount and the binder amount in such a manner as to achieve single layer arrangement, even when the particles are randomly disposed as viewed from the above of the particle layer plane. The particle layer may also contain, in addition to the particles having etching resistance, another kind of particles different therefrom.

### Film mask according to second aspect

A film mask according to the second aspect essentially contains particles containing first particles and second particles, in which the second particles have etching resistance which is lower than that of the first particles. The film mask is typically a particle layer containing a binder and particles blended in the binder. The film mask preferably contains a particle layer and an adhesive layer, in which the particle layer contains a binder and particles blended into the binder, and the adhesive layer serves for adhering a film mask to a process target. The adhesive layer is a functional layer that can be arbitrarily provided in view of increasing the adhesiveness between the film mask and the target substrate. The adhesive layer can be formed of, for example, the binder described below.

The thickness of the particle layer of the film mask according to the second aspect may be, for example, preferably from 0.3 3 µm to 5 µm, and more preferably from 0.5 µm to 2 µm. In contrast, the thickness of the adhesive layer of the film mask according to the second aspect may be, for example, preferably from 0.2 µm to 3 µm, and more preferably from 0.3 µm to 1.5 µm.

The particles which form the particle layer (film mask) include the first particles and the second particles, in which the second particles have etching resistance which is lower than that of the first particles. The particles including these particles are not limited to the two kinds of particles, and may further contain another kind of particles.

The first particles are particles having etching resistance and are not etched by etching. In contrast, the second particles are particles to be etched by etching. Specifically, when an etching rate ER is defined by "(etching rate of the second particles)/(etching rate of the first particles)", the etching rate may be preferably larger than 5 (ER > 5), and more preferably larger than 10 (ER > 10).

In the case that the etching resistance of the first particles is ER1, the etching resistance of the second particles is ER2, and the etching resistance of the binder is ER3, it is preferable to satisfy the relationship of the following Inequality (1). When the relationship is satisfied, the second particles can be etched simultaneously with or before the binder, gaps between the first particles which are generated by etching of the second particles be easily maintained.

### Inequality (1): ER2 < ER1 and ER3 < ER1

Examples of the second particles include resin particles. In particular, thermoplastic resin particles may be preferable in view of easily providing a difference between the etching resistance the second particles from that of the first particles. Examples of the thermoplastic resin particles include acrylic resin particles, polyethylene resin particles, polypropylene resin particles, polyamide particles, polyimide particles, polyethylene terephthalate resin particles, polystyrene particles, and silicone resin.

The blended amount of the first particles and the blended amount of the second particles in the film mask may be the same but, more preferably, the amount of the second particles is larger than that of the first particles. In the case that the amount of the second particles is larger than that of the first particles, overlapping or densely gathering of the first particles may be suppressed and as a result thereof, increase of the number of regions not to be etched or uneven presence of the regions may be suppressed.

### Particles having etching resistance

The "particles having etching resistance" to be contained in the film mask are not particularly limited insofar as they are particles having etching resistance. Examples of the particles include inorganic particles, organic dye particles or organic pigment particles containing inorganic elements, and latex particles or capsule particles containing inorganic elements. Among these, in view of etching resistance, ease in availability, and handling properties, inorganic particles are preferable as the particles.

Examples of the inorganic particles include non-metallic materials such as titanium oxide, silica, calcium carbonate, or strontium carbonate, metals, and semiconductor materials. Examples of the metals include simple metal substance selected from the group consisting of Cu, Au, Ag, Sn, Pt, Pd, Ni, Co, Rh, Ir, Al, Fe, Ru, Os, Mn, Mo, W, Nb, Ta, Bi, Sb, and Pb or alloy materials containing one or two or more selected from the metals. Examples of semiconductors include Si, Ge, AlSb, InP, GaAs, GaP, ZnS, ZnSe, ZnTe, CdS, CdSe, CdTe, PbS, PbSe, PbTe, SeTe, and CuCl. Examples thereof further include microcapsules and the like which encapsulate any of these inorganic particles and having silica as its wall membrane material.
Examples of the organic dye particles and the organic pigment particles containing inorganic elements include metal element-containing azo colorant particles and metal element-containing phthalocyanine colorant particles.
Examples of the latex particles or capsule particles having inorganic elements include particles in which acryl latex is covered with colloidal silica, particles in which acryl latex is covered with silicate, and particles in which polystyrene latex particles are covered with silica.

In the film mask according to the first aspect, the average particle diameter of the particles is preferably from 0.1 µm to 1 µm, and more preferably from 0.2 µm to 0.5 µm, The average particle diameter is preferably in this range from in view of reducing the thickness of the film mask.

In the film mask according to the second aspect, the average particle diameter of the first particles and may be the same as the average particle diameter of the second particles, but the average particle diameter of the second particles is preferably larger than that of the first particles. In the case that the average particle diameter of the second particles is larger than that of the first particles, gaps between the first particles which are generated by etching of the second particles can be easily secured. The average particle diameter of the first particles and the second particles is preferably from 0.1 µm to 1 µm and, more preferably from 0.2 µm to 0.5 µm. The average particle diameter is preferably in this range in view of reducing the thickness of the film mask formed of polymer.

The average particle diameter of the particles herein refers to a particle diameter obtained by a dynamic light scattering method. The measurement method is as follows. The dynamic light scattering method allows measurement of a particle diameter equal to or lower than a submicron range and a distribution of the particle diameter and includes dispersing particles to be measured or a dispersion liquid thereof in a medium by known methods such as emitting ultrasonic waves, and diluting the same as appropriate to be used as a measurement sample. The particle diameter having a 50% cumulative frequency in the cumulative frequency curve of the particle diameter obtained by the dynamic light scattering method can be defined as an average particle diameter. Similarly, the ratio of a particle diameter having a 10% cumulative frequency to a particle diameter having a 90% cumulative frequency can be defined as the index of the particle size distribution. Examples of a measuring device employing such a principle include LB-500 (trade name) manufactured by Horiba.

The particle size distribution of the particles is preferably from 2 to 50, and more preferably from 2 to 10. By adjusting the particle size distribution in this range, the maximum average particle diameter may not become excessively large, a flat film mask layer may be easily obtained, and uniform surface processing becomes may be easily achieved.

A covering ratio of the particles functioning as an etching mask is preferably 5% or more and lower than 60%, more preferably from 10% to 50%, and still more preferably 20% to 40%, with respect to the front surface of the target substrate. The covering ratio may be selected depending on the area of a region to be etched for forming irregularities.

The "covering ratio" refers to a ratio coverage of the target substrate by the particles (particularly the first particles in the case of the second aspect) when the film mask is adhered to the target substrate. More specifically, the "covering ratio" refers to a ratio of the projected area of the particles to be projected to the target substrate from the etching direction to the surface area of the target substrate. The covering ratio can be calculated based on a projected area measured by observing, with using a scanning electron microscope or an optical microscope, the surface of the film mask which has been adhered to the target substrate. In the case of using a scanning electron microscope, a sample can be observed as it is without processing a surface of the sample, and thus the use of a scanning electron microscope may be preferable.

Conditions for forming irregularities on the front surface of the target substrate, i.e., the diameter (equivalent diameter), depth, and processed area ratio of the surface irregularities after etching, can be regulated by regulating the covering ratio of the particles. Specifically, for example, the conditions can be freely designed by regulating the content and the average particle diameter of the particles in the film mask.

Examples of the binder which forms the particle layer include water-soluble polymer materials and organic solvent-soluble polymer materials. Alternatively, depending on a method for manufacturing the film mask, a particle layer may be produced by mixing polymerizable monomers forming each of the polymer materials with other ingredients which form the film mask, and forming a film therefrom by a polymerization reaction caused by light or heat. Examples of the polymerizable monomers include (meth)acrylic acid alkyl esters having 1 to 12 carbon atoms which are (meth)aciylic monomers, and known compounds which are acrylic modifiers that have affinity with the (meth)acrylic monomers and can be used in combination therewith. Examples of the acrylic modifiers include carboxy group-containing monomers and acid anhydride-containing monomers. These polymerizable monomers can be polymerized by known polymerization methods, and initiators, chain transfer agents, oligomer materials, surfactants, and the like required for polymerization can be selected as appropriate from known materials. Examples of the polymerizable monomers include know epoxy monomers and isocyanate monomers.

More specifically, preferable examples of the binder include one having: a glass transition temperature of from -100°C to 50°C; a number average molecular weight of from 1,000 to 200,000, which is preferably from 5,000 to 100,000; and a degree of polymerization of from about 50 to about 1000. Examples of such a binder include polymers or copolymers containing, as a constituent unit, vinyl chloride, vinyl acetate, vinyl alcohol, maleic acid, acrylic acid, acrylic ester, vinylidene chloride, acrylonitrile, methacrylic acid, methacrylic acid ester, styrene, butadiene, ethylene, vinyl butyral, vinyl acetal, vinyl ether, and/or the like, polyurethane resin, various rubber resins, and modified polyvinyl alcohols having a weight average molecular weight of 100000 or lower.

Preferable examples of the binder further include thermosetting resins and reactive resins. Examples of the thermosetting resins and the reactive resins include phenol resin, epoxy resin, polyurethane curable resin, urea resin, melamine resin, alkyd resin, acrylic reactive resin, formaldehyde resins, silicone resin, epoxy-polyamide resin, a mixture of polyester resin and an isocyanate prepolymer, a mixture of polyester polyol and polyisocyanate, and a mixture of polyurethane resin and polyisocyanate. These resins are described in detail in "Plastic Handbook" published by Asakura Shoten. Known electron beam curable resin can also be used. These resins can be used singly or in combination.

Examples of the structure of the polyurethane resin include known polyurethane resin, such as polyester polyurethane, polyether polyurethane, polyether polyester polyurethane, polycarbonate polyurethane, polyester polycarbonate polyurethane, or polycaprolactone polyurethane. All of the polyurethane resins shown here are preferably formed by incorporating, by copolymerization or an addition reaction, at least one polar group selected from -COOM, -SO₃M, - OSO₃M, -P=O (OM)₂, -O-P=O(OM)₂ (wherein M represents a hydrogen atom or an alkaline metal), -NR₂, -N+R₃ (R is a hydrocarbon group), an epoxy group, -SH, -CN, and the like, as required, in order to obtain more excellent dispersibility and durability. The amount of such a polar group may be from 10⁻¹ mol/g to 10⁻⁸ mol/g, and preferably from 10⁻² mol/g to 10⁻⁶ mol/g. In addition to these polar groups, the polyurethane resins preferably have at least one OH group at each terminal of its polyurethane molecule, i.e., the polyurethane resins preferably respectively have two or more OH groups in total. Since the OH group can crosslink with polyisocyanate, which is a curing agent, to form a three-dimensional net structure, the polyurethane resins preferably contain a large number of OH groups in the molecules. The OH groups may be preferably present at a terminal of the molecule since the reactivity with a curing agent of polyurethane resin may become high thereby. The polyurethane resins preferably respectively have three or more OH groups and particularly four or more OH groups at a terminal of the molecule.

In contrast, examples of polyisocyanate include: isocyanates such as tolylene diisocyanate, 4,4'-diphenylmethane diisocyanate, hexamethylene diisocyanate, xylylene diisocyanate, naphtylene-1,5-diisocyanate, o-toluidine diisocyanate, isophorone diisocyanate, and triphenylmethane triisocyanate; products formed from any one or more of these isocyanates and polyalcohol; and polyisocyanates generated by the condensation of any one or more of these isocyanates. The isocyanates are commercially available as CORONATE L, CORONATE HL, CORONATE 2030, CORONATE 2031, MILLIONATE MR, and MILLIONATE MTL (all trade names, manufactured by Nippon Polyurethane Industry Co., Ltd.); TAKENATE D-102, TAKENATE D-110N, TAKENATE D-200, and TAKENATE D-202 (all trade names, manufactured by Takeda Chemical Industries); and DESMODULE L, DESMODULE IL, DESMODULE N, and DESMODULE HL (all trade names, manufactured by Sumitomo Bayer Co., Ltd.). The substances can be used singly or in combination of two or more thereof utilizing curing reactivity differences.

The glass transition temperature of the binder is preferably 50°C or lower, more preferably from -60°C to 30°C, and still more preferably from -50°C to 30°C. The glass transition temperature is preferably in this range in view of increasing the storability of the film mask (surface processing mask), handling properties in forming irregularities, and adhesiveness with the target substrate.
The glass transition temperature can be herein measured using the film mask material as a sample and using known thermal analysis devices or mechanical property measuring devices. The glass transition temperature is preferably measured by a dynamic viscoelasticity measuring device under the conditions of a bending mode, a measurement frequency of 1 Hz, and a temperature elevation rate of 5°C/minute.

Examples of the binder further include polyvinyl alcohol, polyvinyl alcohol derivatives, cellulose derivatives (such as polyvinyl pyrrolidone, carboxymethylcellulose and hydroxyethylcellulose), natural polysaccharides, derivatives of natural polysaccharides (such as starch, xanthan gum, and alginic acid), water-dispersible urethane, and acrylic polymer latex.

In the film mask according to the first aspect, the content of the binder in the particle layer is such an amount that the volume of the binder becomes smaller than the total volume of the particles so that the particles are exposed from the particle layer when the particle layer is formed. In order to achieve single layer arrangement of the particles blended in the particle layer, the content of the binder may be preferably smaller. However, when the amount of the binder is excessively small, there is a possibility that the particles are not bound to each other, and thus it may be preferable that a moderate amount of the binder is present. The content of the binder that is expressed by the volume of the binder (dried), the content may be typically from 1/ 10 to 3/5, preferably from 1/8 to 1/2, and more preferably from 1/5 to 1/3, base on the volume of all the particles.

In the film mask according to the second aspect, the content of the binder in the particle layer may be determined as appropriate according to the dispersibility of the particles. For example, it may be preferably from 5% by weight to 50% by weight, and more preferably from 10% by weight to 30% by weight, based on the content of the particles.

Examples of other ingredients which form the particle layer (and consequently form the film mask) include: a dispersing agent capable of stably dispersing the particles; a release agent for adjusting adhesive strength with the support substrate, the protective film or the like; a surfactant for adjusting the viscosity and surface tension of coating liquids during manufacturing; and a solvent.
In particular, examples of the dispersing agent include phenylphosphonic acid, which may be specifically "PPA" (trade name, manufactured by Nissan Chemical Industries, Ltd.), α-naphthyl phosphoric acid, phenyl phosphoric acid, diphenyl phosphoric acid, p-ethyl benzene phosphonic acid, phenyl phosphinic acid, aminoquinones, various silane coupling agents, titanium coupling agents, fluoride-containing alkyl sulfate ester, and an alkali metal salt thereof. Examples of the dispersing agent further include: nonioinc surfactants such as an alkylene oxide surfactants, a glycerin surfactants, a glycidol surfactants, and alkyl phenol ethylene oxides; cationic surfactants such as cyclic amine, ester amide, quartenary ammonium salts, hydantoin derivatives, heterocyclics, phosphoniums, and sulfoniums; anionic surfactants containing acidic groups such as carboxylic acid, sulfonic acid, phosphoric acid, a sulfate ester group, and a phosphoric acid ester group; and amphoteric surfactants such as amino acids, sulfamic acids, phosphoric acid or phosphoric acid ester of amino alcohol, and an alkyl betaine surfactants. Examples of the dispersing agent further include polyoxyethylene alkyl phenyl ether, a polyoxy alkylene block copolymer, polyoxyethylene alkyl phenyl ether having a polymerizable unsaturated bond such as an allyl group. These dispersing agents (surfactants) are described in detail in "Kaimenkasseizai Binran" (published by Sangyo Tosho). These dispersing agents may not necessarily be completely pure and may contain impurities such as isomers, unreacted materials, side-reacted materials, decomposed materials, or oxides, in addition to their main ingredients. The content of these impurities may be preferably 30 mass% or lower and more preferably 10 mass% or lower based on the amount of the respective dispersing agent. Monoesters and diesters in combination as fatty ester described in WO No. 98/35345 pamphlet may be also preferably used as the dispersing agent.

A coating liquid for forming the particle layer (first coating liquid) may be formed by, for example, dispersing or dissolving each component in a solvent (e.g., a water-based solvent and/or an organic solvent).

The binder layer is a layer which is other than the particle layer and is formed so as to cover the exposed particles in the particle layer. The binder layer can be utilized as a layer functioning as a layer that increases adhesion of the film mask and the target substrate and also as a layer functioning as an adhesive layer (particularly thermal adhesive layer that exhibits adhesiveness by heating). The binder layer may function particularly as an adhesive layer (thermal adhesive layer) in the case that it contains the binder described above.

A coating liquid for forming the binder layer (second coating liquid) may be formed by, for example, dispersing or dissolving each component in a solvent (e.g., a water-based solvent and an organic solvent).

Although the film mask applied as the surface processing mask contained the particles which are blended in the binder in the surface processing method according to the above-described exemplary embodiment of the second aspect of the invention, the scope of the embodiment is not limited thereto. For example, in another exemplary embodiment, the particles themselves may be applied as the surface processing mask. More specifically, such another exemplary embodiment may include disposing, on the target substrate (process target) particles which contains a mixture of the first particles and the second particles having etching resistance lower than that of the first particles by applying the particles on the target substrate (process target), and then performing etching. Also in this exemplary embodiment, a surface processing method that rarely causes inconsistent quality even when a process target has a large area, can form irregularities at a high speed, and has excellent aptitude to mass production and cost reduction may be achieved.

### Support substrate

Examples of the support substrate include a resin film. Examples of the resin film include resin films formed from polyester (e.g., polyethylene terephthalate and polyethylenenaphthalate), polyphenylene sulfide, polyimide or the like or a mixture of any of these. The release force of the film mask from a surface of the support substrate on which the film mask is formed can be optimized by appropriately regulating interface energy of the surface. Preferable examples of a method for regulating the interface energy include formation of a silicon release agent layer. Specific examples of the silicon release agent layer formation include application of a silicon surfactant, formation of an applied-and-cured layer of an ionizing radiation polymerizable silicon monomer, and formation of an applied layer of organosiloxane polymer. Examples of a method for regulating the interface energy further include application of a fluorochemical surfactant.

The thickness of the support substrate is preferably from 30 µm to 300 µm and more preferably from 50 µm to 100 µm. The thickness is preferably in this range in view of providing self-supporting properties to the surface processing mask and improving handling properties in storing the support substrate or adhering the support substrate to the target substrate.

The adhesive strength which works between the support substrate and the film mask is preferably lower than the adhesive strength which works between the film mask and the target substrate (the force required for releasing the support substrate from the film mask). In the case that this condition is achieved, release of the film mask from the target substrate can be suppressed when releasing the support substrate from the film mask.
Specifically, the adhesive strength between the support substrate and the film mask is preferably 5 N/10 mm is lower, more preferably from 0.01 N/10 mm to 1 N/10 mm, and still more preferably from 0.05 N/10 mm to 1 N/10 mm.

Here, the adhesive strength can be measured by the method specified in Japanese Industrial Standards (JIS) or American Society for Testing and Materials (ASTM), i.e., a 180° releasing method, and refers to an average load required for release per unit width of a layer provided on a base when releasing the layer with a degree of 180° and a rate of 6 in/min (about 152.4 mm/min) (ASTM D-903).

In the case that the above adhesive strength cannot be achieved between the support substrate and the film mask, a release layer described below may be preferably provided.

### Protective film

A protective film is a layer disposed onto a surface of the film mask which is opposite to the surface at which the film mask adheres to the substrate support in order to cover and protect the opposite surface. Examples of the protective film include a polymer film containing an aliphatic polymer or an aromatic polymer. Specific examples thereof include a polyethylene film, a polypropylene film, and a polyethylene terephthalate film. The polymer film may be used singly or may be in combination of a layer formed by applying thereto a polymer material such as acrylic materials, rubber or ethylene vinyl copolymers, which are referred to as adhesives.

The thickness of the protective film is preferably from 30 µm to 100 µm, and more preferably from 40 µm to 70 µm. The thickness may be in this range in view of protecting the surface of the film mask adhered to the target substrate and improving the handling properties of the process target mask.

The adhesive strength which works between the protective film and the film mask is preferably lower than the adhesive strength which works between the film mask and the target substrate (the force required for releasing the protective film from the film mask). In the case that this condition is achieved, release of the film mask from the target substrate can be suppressed when releasing the protective film from the film mask.
The adhesive strength between the protective film and the film mask is preferably from 5 N/10 mm or lower, more preferably from 0.01 N/10 mm to 1 N/10 mm, and still more preferably from 0.05 N/10 mm to 1 N/10 mm. When the protective film it not adhered to the film mask but merely inserted as a so-called "inserting paper", the adhesive strength between the protective film and the film mask is substantially zero.

### Release layer

A release layer is a layer for improving the releasability between the film mask and the support substrate. Examples of the release layer include a thermoplastic resin layer. The thickness thereof is typically lower than 15 pin and preferably lower than 5 µm. Preferable examples of thermoplastic resin which forms the thermoplastic resin layer include a binder which forms the film mask. The glass transition temperature of the thermoplastic resin is preferably from 10°C- to 50°C- higher than the glass transition temperature of the binder which forms the film mask. In the case that the glass transition temperature is in this range, defects such as cracks or fracture may hardly occur in the thermoplastic resin layer which is the intermediate layer in the pressure welding process to the target substrate, and the thermoplastic resin layer may easily separate from the support substrate. In the case that the thickness of the thermoplastic resin layer is set in this range, deterioration of the productivity due to an increase of the processing time in the etching process can be suppressed.

Examples of the release layer include a fluorine material layer. Examples of a fluorine material which forms the fluorine material layer include anionic fluorine materials (e.g., perfluoroalkyl carboxylate, perfluoroalkyl sulfonate, and perfluoroalkyl phosphate), amphoteric fluorine materials (e.g., perfluoroalkyl betaine), cationic fluorine materials (e.g., perfluoroalkyl trimethylammonium salt), and non-ionic fluorine materials (e.g., a perfluoroalkyl amine oxide; a perfluoroalkyl ethylene oxide adduct; an oligomer containing perfluoroalkyl group and a hydrophilic group; and a perfluoroalkyl group, and an urethane containing perfluoroalkyl group and lipophilic group). The fluorine material may be added to the thermoplastic resin layer (the release layer) or the film mask (particle layer) to thereby increase the releasability.

### Non-adhesive layer

A non-adhesive layer is a layer for suppressing adhesion of the surface processing masks when plural surface processing masks are stacked or for suppressing adhesion of inner regions of the surface processing mask when the surface processing mask is formed into a roll shape. Preferable examples of the non-adhesive layer include the fluorine material layer. The thickness is typically lower than lower than 15 µm, and preferably lower than 5 µm.

### Method for manufacturing surface processing mask

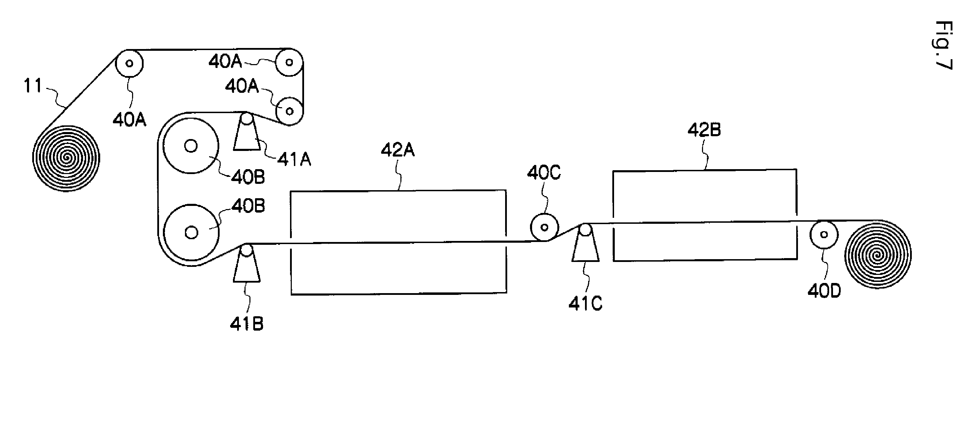

Figs. 6A to 6F each are views of processes in a method for manufacturing a surface processing mask according to an exemplary embodiment of the first aspect of the invention. Fig. 7 is a schematic configuration diagram showing a device for manufacturing the surface processing mask according to the exemplary embodiment. Only the method for manufacturing a surface processing mask and a device for manufacturing the same according to the first aspect of the invention will be herein described in detail, but it will be readily understood by those skilled in the art that the method for manufacturing a surface processing mask and a device for manufacturing the same according to the second aspect can be similar to those of the first aspect.

As shown in Fig. 7, the manufacturing method includes delivering the support substrate rolled in a roll shape, applying and drying each layer in a path for conveying the same, and then winding the obtained product to obtain a surface processing mask.

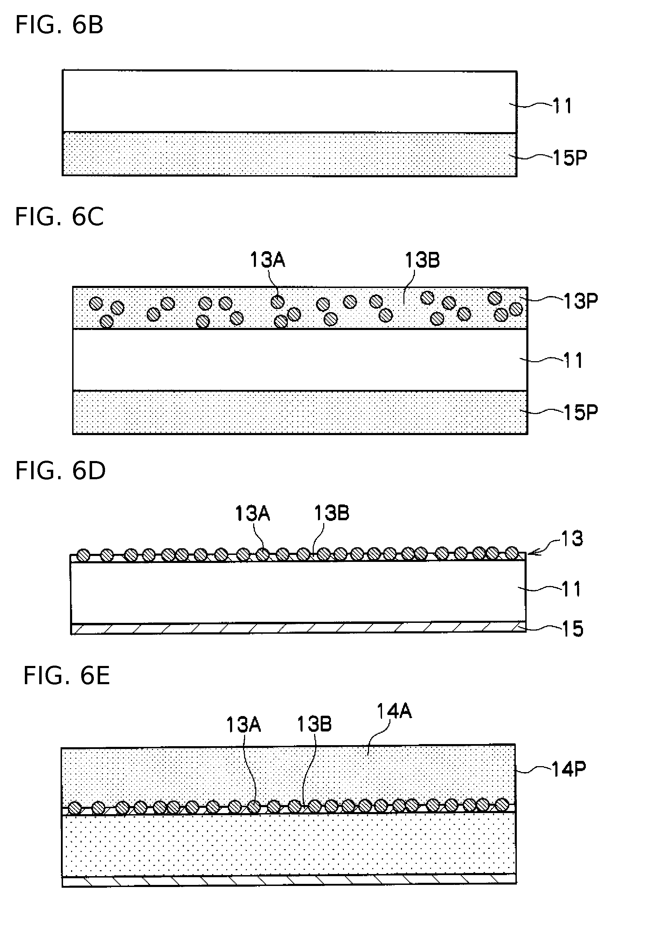

Specifically, for example, a coating liquid for forming a non-adhesive layer is applied to the rear surface of the support substrate 11 by a coating device 41A which can be a rod bar or the like, while delivering, by a delivering device (not shown), the support substrate 11 (sheet) which is rolled in a roll shape (Fig. 6A), and curving and conveying the sheet by a contact type conveying roller 40A, thereby forming a coating film 15P for forming a non-adhesive layer (Fig. 6B), as shown in Fig. 7.

Next, after the application of the coating liquid for forming a non-adhesive layer, a coating liquid for forming a particle layer, which is directed to form the film mask, is applied to the front surface of the support substrate 11 by a coating device 41B which can be a rod bar or the like, while curving and conveying the support substrate by a non-contact conveying roller 40B, thereby forming a coating film 13P for forming particle layer (Fig. 6C).

Next, after the application of the coating liquid for forming the particle layer, the support substrate 11 is conveyed into a drying device 42A to dry each coating film to thereby form a non-adhesive layer 15 on the rear surface of the support substrate and the particle layer 13 on the front surface of the support substrate. (In embodiments according to the first aspect, the particle layer 13 may be formed as one having exposed the particles 13A which are arranged to form a single layer arrangement (Fig. 6D) at this stage).

Next, a coating liquid, which is directed to form a binder layer which forms the film mask, is applied to the front surface of the particle layer 13 formed on the support substrate by a coating device 41 C which can be a rod bar or the like, while conveying the resultant by the contact type conveying roller 40C, thereby forming a coating film 14P for forming a binder layer (Fig. 6E).

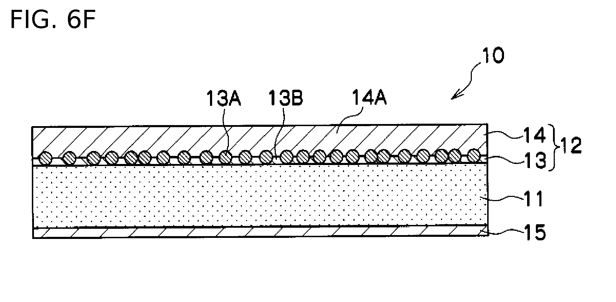

After the application of the coating liquid for forming a binder layer, the support substrate 11 is conveyed into a drying device 42B to dry the coating film to thereby form the binder layer 14 on the particle layer 13 of the support substrate 11 (Fig. 6F). (In embodiments according to the first aspect, the binder layer 14 is formed in such a manner as to cover the exposed particles 13A of the particle layer 13.) A film mask 12 containing the particle layer 13 and the binder layer 14 is thus formed.

Thereafter, the resultant obtained by forming each layer on the support substrate (namely, a surface processing mask) is wound in a roll shape again by a winding device (not shown) while conveying the resultant by a contact type conveying roller 40D. Thus, the surface processing mask 10 is obtained.

The coating method of each coating liquid is not limited to the bar coating method using a rod bar, and may be selected from a roll coating method, a curtain coating method, an air knife coating method, and gravure coating method.

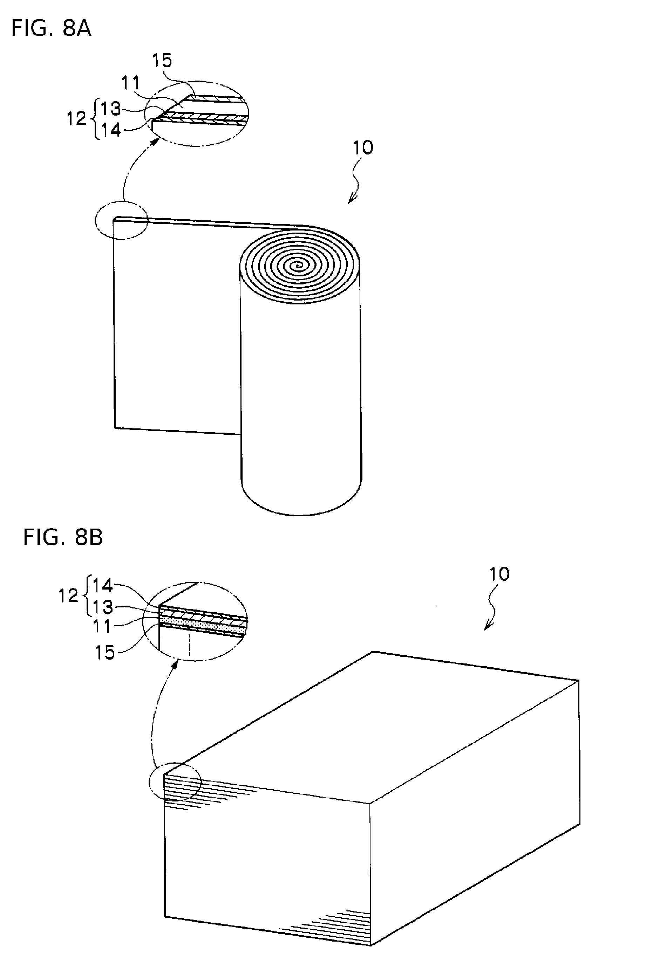

The surface processing mask described above may be stored, traded, and used in a state where the surface processing mask is wound in a roll shape as shown in Fig. 8A, or may be stored, traded, and used in a sheet-like laminated state as shown in Fig. 8B. Here, Figs. 8A and 8B are perspective views showing the storage shape of the surface processing mask of exemplary embodiments. Fig. 8A shows the surface processing mask in a roll shape, and Fig. 8B shows a plurality of the surface processing masks which respectively have a sheet shape and are stacked.

Preferable examples of an irregularity formation process to which the surface processing method (surface processing mask) according to any one of the exemplary embodiments is applied include: 1) processes for forming irregularities on a light transmitting surface of a substrate by etching in order to suppress a reflection which occurs when light transmits an interface of materials having a large refractive-index difference, the processes being performed in the fields of optical devices such as solar cells, LEDs, and flat panel displays; and 2) processes for forming irregularities on a substrate surface in order to obtain an anchor effect for suppressing release of a thin film from a substrate resulting from insufficient adhesiveness between the thin film and the substrate, the processes being performed in the field of semiconductor devices.

In the case that the surface processing mask is applied to the fields of optical devices, the surface (processed surface) of a process target (substrate) on which irregularities are formed is preferably a light incident surface of optical devices. This may efficiently suppress the reflection phenomenon of the optical devices. Preferable typical examples of optical devices having a substance processed by the surface processing method according to any one of the exemplary embodiments include a solar cell having a substrate as the processed substance. The solar cell may have know structure, except that it has a substrate processed by the surface processing method according to any one of the exemplary embodiments. For example, the solar cell may have a structure containing the substrate, a pair of electrodes, and a photovoltaic layer disposed between the pair of electrodes.

In particular, in the surface processing mask (film mask) applied to the surface processing method according to exemplary embodiments of the first aspect of the invention and the method for manufacturing the same, particles are arranged to form a single layer without overlapping with each other. Thus, the surface processing mask and the manufacturing method can be applied not only to the surface processing method but also as, for example, a particle-containing film (film mask) to be utilized in the fields of optical films (e.g., antireflection films, brightness increasing films, diffusion films, and reflective sheets), memory media, and semiconductors and methods for manufacturing each.

### EXAMPLES

Hereinafter, the invention will be more specifically described with reference to examples. However, each example does not limit the invention.

### Coating liquids to be used are as follows.

### Coating liquid 1-1

6 parts by weight of silica particles (trade name: SP-03F, manufactured by Fuso Chemical Co., Ltd., average particle diameter: 0.3 µm) and 0.5 parts by weight of a dispersing agent (sodium 2-ethylhexyl sulfosuccinate) were added to 100 parts by weight of an aqueous solution containing 2%-PVA (manufactured by Kuraray), and the resulted mixture was subjected to dispersing in a dissolver to provide a coating liquid 1. The content of the PVA (binder) in the coating liquid 1 in terms of volume after drying was 1/3 of that of the silica particles.

### Coating liquid 1-2

6 parts by weight of silica particles (first particles, trade name: SP-03F, manufactured by Fuso Chemical Co., Ltd., average particle diameter: 0.3 µm), 4 parts by weight of acrylic resin particles (second particles, trade name: MP1000, manufactured by Soken Chemical & Engineering Co., Ltd., average particle diameter: 0.4 µm) to 100 parts by weight of an aqueous solution containing 3%-PVA (manufactured by Kuraray), and 0.5 parts by weight of a dispersing agent (sodium 2-ethylhexyl sulfosuccinate) were added, and the resulted mixture was subjected to dispersing in a dissolver to provide a coating liquid 1-2.

### Coating liquid 2

0.5 parts by weight of sodium 2-ethylhexyl sulfosuccinate) was added to 100 parts by weight of an aqueous solution containing 3%-PVA (manufactured by Kuraray) to provide a coating liquid 2.

### Coating liquid 3

1 part by weight of a fluorosurfactant (perfluoroalkyl sulfonate) was added to 100 parts by weight of an aqueous solution containing 2%-PVA (manufactured by Kuraray) to provide a coating liquid 3.

### Coating liquid 4-1

6 parts by weight of silica particle (trade name: SP-03F, manufactured by Fuso Chemical Co., Ltd., average particle diameter: 0.3 µm) and 0.5 parts by weight of a dispersing agent (sodium 2-ethylhexyl sulfosuccinate) were added to 100 parts by weight of an aqueous solution containing 9%-PVA (manufactured by Kuraray), and the resulted mixture was subjected to dispersing in a dissolver to provide a coating liquid 4. The content of the PVA (binder) in the coating liquid 4 in terms of volume after drying was 3/2 of that of the silica particles.

### Example 1 (exemplary embodiment of the first aspect)

First, a surface processing mask was produced as follows.
A polyethylene terephthalate (PET) substrate (support base material) having a size of 300 mm × 500 mm and a thickness of 70 µm was prepared.
Next, the coating liquid 1-1 was applied to the front surface of the PET substrate surface by using a rod bar so that the resulted wet film had a thickness (PVA film thickness) of 2 µm, and then the resulted wet film was dried at 80°C for 3 minutes to form a particle layer. In the particle layer, the silica particles were exposed and were arranged to form a single layer without overlapping with each other. Next, the coating liquid 2 was applied to the front surface of the particle layer (surface on which the particles are exposed) by using a rod bar so that the wet film had a thickness of 2 µm, and then the resulted wet film was dried at 60°C for 2 minutes to form a binder layer (adhesive layer).
Thus, a surface processing mask in which the film mask containing the particle layer and the adhesive layer was disposed on the PET substrate (support substrate) was produced.

Then, using the obtained surface processing mask, surface processing was performed as follows to form irregularities on the front surface of a silicon substrate (a process target having a diameter of 100 mm and a thickness of 0.3 mm).

First, the surface processing mask is disposed on the surface of the silicon substrate so that the film mask faces the silicon substrate. Next, the silicon substrate on which the surface processing mask is disposed is inserted into a laminate device, and is held by holding rolls under a condition of vacuum decompression (50 hPa) and a temperature of 60°C so that the surface processing mask (film mask) and the silicon substrate are pressure-welded. Thereafter, the support substrate was released from the film mask to form a silicon substrate having the film mask adhered to the front surface thereof.

Next, the silicon substrate having the film mask adhered thereto was first subjected to reactive ion etching using oxygen containing gas to remove regions other than the regions covered with the silica particle of the particle layer (namely, regions formed of the acrylic resin particles, the binder of the particle layer, and the thermal adhesive layer are removed). Dry etching was further carried out for 30 seconds at 150 W under the presence of SF₆ gas using the silica particles as a mask. Thereafter, nitrogen gas purge was carried out, oxygen gas was introduced, and then surface processing was carried out using oxygen plasma at 300 W for 30 seconds. When the silicon substrate surface was observed under a scanning electron microscope and AFM, a concave-convex structure having a diameter of about 0.5 µm and a depth of about 0.2 µm was observed on the silicon substrate surface. (The "diameter" hereinafter means at least 60% equivalent diameter based on the total number of irregularities on the silicon substrate surface.)

### Example 2 (exemplary embodiment of the first aspect)

A surface processing mask was produced with employing a method having a mass-production suitability compared with that employed in Example 1 as follows (Fig. 7).
The coating liquid 3 was applied, by using a rod bar, to the rear surface of a polyethylene terephthalate (PET) sheet which is in a roll shape and has a width of 1500 mm and a thickness of 70 µm at 50 m/min so that the wet film had a thickness of 2 µm while running the PET sheet from a delivering device, and then the coating liquid 1-1 was applied to the front surface of the PET sheet by using a rod bar so that the wet film had a thickness (PVA film thickness) of 2 µm. Thereafter, the PET sheet was conveyed to a drying device to be dried at 80°C for 3 minutes to form a non-adhesive layer on the rear surface of the PET sheet and also to form a particle layer on the front surface of the PET sheet.

Next, the coating liquid 2 was applied, by using a rod bar, to the front surface of the particle layer (surface on which the particles are exposed) while conveying the PET sheet on which the non-adhesive layer and the particle layer were formed so that the dry film had a thickness of 2 µm, and then conveyed to a drying device to be dried at 60°C for 2 minutes to form an adhesive layer. Thereafter, the PET sheet on which each layer was formed was wound by using a winding device to form a roll shape.
Thus, a surface processing mask having a non-adhesive layer on the rear surface of the PET sheet (support substrate)and having the film mask containing the particle layer and the adhesive layer on the front surface thereof was produced. Mass production and cost reduction may be achieved by manufacturing the surface processing mask in such a continuous and roll-to-roll manner.

The thus obtained roll-shaped surface processing mask was cut into a given size. Irregularities were formed on a front surface of a silicon substrate using the resultant in the similar manner as in Example 1. As a result, the irregularities similar to those of Example 1 were formed on the silicon substrate.

### Comparative example 1

Production of a surface processing mask of Comparative example 1 was attempted in the similar manner as that in Example 1.
Specifically, the coating liquid 4 was applied by using a rod bar to a front surface of the PET substrate so that the wet film had a thickness (PVA film thickness) of 2 µm, and dried at 80°C for 3 minutes to form a particle layer. When the particle layer was observed, problems such as overlapping of particles and particle omission were noticeably found. A desired single layer arrangement was not herein achieved.

### Example 3 (exemplary embodiment of the second aspect)

A surface processing mask on which a film mask was disposed was produced under the similar conditions as those in Example 1, except that the coating liquid 1-2 was used in place of the coating liquid 1-1 (and as a result thereof, a surface on which particles are exposed was not produced in the formation of a particle layer). Then, etching (irregularity formation) using the surface processing mask was performed, thereby obtaining a surface-processed silicon substrate.
When the silicon substrate surface was observed under a scanning electron microscope and AFM, a concave-convex structure having a diameter of about 0.5 µm and a depth of about 0.2 µm was observed on the silicon substrate surface. (The "diameter" hereinafter means at least 60% equivalent diameter based on the total number of irregularities on the silicon substrate surface.)

### Example 4 (exemplary embodiment of the second aspect)

The coating liquid 3 was applied, by using a rod bar, to the rear surface of a polyethylene terephthalate (PET) sheet which is in a roll shape and has a width of 1500 mm and a thickness of 70 µm at 50 m/min so that the dry film had a thickness of 1 nm while running the PET sheet from a delivering device, and then the coating liquid 2 was applied to the front surface of the PET sheet by using a rod bar so that the dry film had a thickness of 1 µm. Thereafter, the PET sheet was conveyed to a drying device to be dried at 80°C for 3 minutes to form a non-adhesive layer on the rear surface of the PET sheet and also to form a particle layer on the front surface of the PET sheet.

Next, the coating liquid 2 was applied, by using a rod bar, to the front surface of the particle layer while conveying the PET sheet on which the non-adhesive layer and the particle layer were formed so that the dry film had a thickness of 2 µm, and then conveyed to a drying device to be dried at 60°C for 2 minutes to form an adhesive layer. Thereafter, the PET sheet on which each layer was formed was wound by using a winding device to form a roll shape.
Thus, a surface processing mask having a non-adhesive layer on the rear surface of the PET sheet (support substrate)and having the film mask containing the particle layer and the adhesive layer on the front surface thereof was produced. Mass production and cost reduction may be achieved by manufacturing the surface processing mask in such a continuous and roll-to-roll manner.

The thus obtained roll-shaped surface processing mask was cut into a given size. Irregularities were formed on a front surface of a silicon substrate using the resultant in the similar manner as in Example 3. As a result, the irregularities similar to those of Example 3 were formed on the silicon substrate.

### Comparative example 2

A polyethylene terephthalate (PET) substrate (support base material) having a size of 300 mm × 500 mm and a thickness of 70 µm was prepared.

The coating liquid 4 was applied to the front surface of the PET substrate surface by using a rod bar so that the resulted dry film had a thickness of 1 µm, and then the resulted wet film was dried at 80°C for 3 minutes to form a particle layer. Next, the coating liquid 2 was applied to the front surface of the particle layer by using a rod bar so that the dry film had a thickness of 2 µm, and then the resulted wet film was dried at 60°C for 2 minutes to form an adhesive layer. Thus, a surface processing mask in which the film mask containing the particle layer and the adhesive layer was disposed on the PET substrate (support substrate) was produced.

Using the thus obtained surface processing mask, a surface processing was performed under the similar conditions as those in Example 1.
When the silicon substrate surface was observed under a scanning electron microscope and AFM, it was found that the front surface of the silicon substrate was etched only in several percentages of the whole surface, and a concave-convex structure was not formed.
Etching was further performed several times while lengthening the etching time. However, an etching condition which achieves a concave-convex structure did not found.

### Description of Reference numerals:

- 10: Surface processing mask
- 11: Support substrate
- 12: Film mask
- 13: Particle layer
- 13A: Particles
- 13B: Binder
- 13P: Coating film for forming particle layer
- 14: Binder layer
- 14A: Binder
- 14P: Coating film for forming binder layer
- 15: Non-adhesive layer (Binder)
- 15P: Coating film for forming non-adhesive layer
- 16: Particles
- 16A: First particles
- 16B: Second particles
- 20: Target substrate
- 30: Laminate device
- 31: Holding roller
- 40A to 40D: Contact type conveying roll
- 41A to 40C: Coating device
- 42A, 40B: Drying device

## Claims

1. A surface processing mask to form irregularities on a front surface of a process target, the surface processing mask comprising a film mask, and the film mask comprising:
a particle layer comprising particles and a first binder, a content of the first binder in the particle layer being less than a content of the particles in the particle layer in terms of volume, and the particles being exposed from the first binder; and
a binder layer comprising a second binder and including portions of the particles which are exposed from the first binder.

2. A surface processing mask to form irregularities on a front surface of a process target, the surface processing mask comprising a film mask, the film mask comprising at least particles comprising first particles and second particles, and the second particles having an etching resistance that is less than an etching resistance of the first particles.

3. The surface processing mask of claim 2, wherein the film mask further comprises a binder.

4. The surface processing mask of claim 2 or 3, wherein ER1, which is an etching resistance of the first particles, ER2, which is an etching resistance of the second particles, and ER3, which is an etching resistance of the binder, satisfy the inequalities of ER2 < ER1 and ER3 < ER1.

5. The surface processing mask according to any one of claims 2 to 4, wherein the first particles are inorganic particles and the second particles are thermoplastic resin particles.

6. The surface processing mask according to any one of claims 2 to 5, wherein a content of the second particles is greater than a content of the first particles.

7. The surface processing mask of claim 1, wherein the binder layer is an adhesive layer that adheres the film mask to the process target.

8. The surface processing mask according to any one of claims 1 to 7, further comprising an adhesive layer that adheres the film mask to the process target.

9. The surface processing mask according to any one of claims 1 to 8, comprising a support substrate that supports a main surface of the film mask.

10. The surface processing mask of claim 9, comprising a release layer between the support substrate and the film mask.

11. The surface processing mask of claim 9 or 10, comprising a non-adhesive layer disposed on a surface that is opposite to the surface of the support substrate on which the film mask is disposed.

12. The surface processing mask according to any one of claims 9 to 11, comprising a protective film that covers another main surface that is opposite to the surface supported by the support substrate of the film mask.

13. The surface processing mask according to any one of claims 1 to 12, wherein the surface processing mask is roll-shaped or sheet-shaped.

14. A surface processing method to forming irregularities on a front surface of a process target, the method comprising:
disposing the surface processing mask according to any one of claims 1 to 13 on the front surface of the process target; and
etching the front surface of the process target on which the surface processing mask is disposed to form irregularities on the front surface of the process target.

15. The surface processing method of claim 14, wherein:
a main surface of the film mask of the surface processing film is supported by a support substrate; and
disposing includes disposing the film mask on the front surface of the process target and then releasing the support substrate from the film mask.

16. The surface processing method of claim 14 or 15, wherein:
another main surface of the film mask that is opposite to the surface supported by the support substrate is covered with a protective film; and
the surface processing method includes releasing the protective film from the film mask before disposing.

17. The surface processing method according to any one of claims 14 to 16, wherein the disposing includes holding the film mask and the process target by using a roller under at least one of a vacuum decompression condition or a temperature condition higher than a glass transition temperature of the binder in the binder layer, so as to adhere the film mask and the process target.

18. The surface processing method according to any one of claims 14 to 17, wherein the etching is a dry etching.

19. The surface processing method according to any one of claims 14 to 18, wherein the front surface of the process target on which irregularities are to be formed is a light incident surface of an optical device.

20. An optical device comprising a substrate, the substrate resulting from being subjected to the surface processing method according to any one of claims 14 to 19.

21. A method of manufacturing a surface processing mask to form irregularities on a front surface of a process target, the method comprising forming a film mask comprising a particle layer and a binder layer, and the film mask forming comprising: forming the particle layer comprising a first binder and particles exposed from the first binder by applying and drying a first coating liquid onto a base material, the first coating liquid comprising the particles and the first binder, a dry content of the first binder in the first coating liquid being less than a dry content of the particles in the first coating liquid in terms of volume; and
forming the binder layer by applying, onto the particle layer, a second coating liquid comprising a second binder so that the exposed particles are covered, and drying the applied second coating liquid.

22. The method of manufacturing a surface processing mask of claim 21, wherein the binder layer is an adhesive layer which adheres the film mask to the process target.

23. A method of manufacturing a surface processing mask to form irregularities on a front surface of a process target, the method comprising forming a film mask comprising a particle layer, and the film mask forming comprising forming the particle layer by applying and drying a coating composition for forming a particle layer onto a base material, the coating composition comprising first particles and second particles, and the second particles having an etching resistance that is less than an etching resistance of the first particles.

24. The method of manufacturing a surface processing mask of claim 23, further comprising applying a coating composition to form an adhesive layer onto the particle layer and drying the coating composition to form an adhesive layer.

25. The method of manufacturing a surface processing mask according to any one of claims 21 to 24, wherein the base material is a support substrate that supports a main surface of the film mask.

26. The method of manufacturing a surface processing mask according to any one of claims 21 to 25, comprising forming a release layer between the base material and the film mask.

27. The method of manufacturing a surface processing mask according to any one of claims 21 to 26, comprising forming a non-adhesive layer on a surface that is opposite to a surface of the base material on which the film mask is formed.

28. The method of manufacturing a surface processing mask according to any one of claims 21 to 27, comprising forming a protective film on the film mask.

29. The method of manufacturing a surface processing mask according to any one of claims 21 to 28, wherein a method of applying the first coating liquid and the second coating liquid in the formation of the film mask is selected from a bar coating method, a roll coating method, a curtain coating method, an air knife coating method, and a gravure coating method.

30. A method of manufacturing a particle-containing film, the method comprising:
forming the particle layer comprising a first binder and particles exposed from the first binder by applying and drying a first coating liquid onto a base material, the first coating liquid comprising the particles and the first binder, a dry content of the first binder in the first coating liquid being less than a dry content of the particles in the first coating liquid in terms of volume; and
forming the binder layer by applying, onto the particle layer, a second coating liquid comprising a second binder so that the exposed particles are covered, and drying the applied second coating liquid.

31. A method of manufacturing a particle-containing film, the method comprising forming a particle layer by applying and drying a coating composition for forming a particle layer onto a base material,, the coating composition comprising first particles and second particles, and the second particles having an etching resistance that is less than an etching resistance of the first particles.

32. The method of manufacturing a particle-containing film of claim 30 or 31, wherein a method of applying the first coating liquid and the second coating liquid is selected from a bar coating method, a roll coating method, a curtain coating method, an air knife coating method, and a gravure coating method.

33. A particle-containing film comprising:
a particle layer comprising particles and a first binder, a content of the first binder in the particle layer being less than a content of the particles in the particle layer in terms of volume; and
a binder layer comprising a second binder, the particles being exposed from the first binder.

34. A particle-containing film comprising first particles and second particles, the second particles having an etching resistance that is less than an etching resistance of the first particles.

35. The particle-containing film of claim 33 or 34, wherein the film is roll-shaped or sheet-shaped.
